Europäisches Patentamt

European Patent Office

Office européen des brevets

(11) Veröffentlichungsnummer: **0 349 946**

**A1**

(12) # EUROPÄISCHE PATENTANMELDUNG

(21) Anmeldenummer: **89112069.3**

(51) Int. Cl.4: **C23C 18/14**

(22) Anmeldetag: **01.07.89**

(30) Priorität: **02.07.88 DE 3822494**

(43) Veröffentlichungstag der Anmeldung:
**10.01.90 Patentblatt 90/02**

(84) Benannte Vertragsstaaten:
**CH DE FR GB LI NL**

(71) Anmelder: **Asea Brown Boveri
Aktiengesellschaft
Kallstadter Strasse 1
D-6800 Mannheim 31(DE)**

(72) Erfinder: **Esrom, Hilmar, Dr. rer. nat.
Dipl.-Phys.
Fritz-Frey-Strasse 11
D-6900 Heidelberg(DE)**

(74) Vertreter: **Rupprecht, Klaus, Dipl.-Ing. et al
c/o Asea Brown Boveri Aktiengesellschaft
Zentralbereich Patente Postfach 100351
D-6800 Mannheim 1(DE)**

(54) **Verfahren zur Herstellung von metallischen Schichten.**

(57) Die Erfindung bezieht sich auf ein Verfahren zur Herstellung von ganzflächigen oder partiellen metallischen Schichten (2M) auf einem Substrat (1) aus einem organischen oder anorganischen Werkstoff. Die metallischen Schichten (2M) werden bis jetzt durch Auftragen einer Lösung, in der eine metallorganische Verbindung gelöst ist, auf dem Substrat (1) ausgebildet. Der aufgetragene Lösungsfilm wird anschließend getrocknet und dem Einfluß einer Lichtquelle hoher Leistung ausgesetzt. Hieran schließen sich weitere Behandlungsschritte an. Der Erfindung liegt die Aufgabe zugrunde, ein Verfahren aufzuzeigen, mit dem metallische Schichten einfacher und energiesparender auf Substrate (1) aufgetragen werden können. Hierfür wird eine pulverförmige metallorganische Verbindung oder eine Lösung, die eine solche metallorganische Verbindung (2) enthält, auf ein Substrat (1) aufgetragen. Anschließend wird die Oberfläche (1S) des Substrats (1) der Einwirkung eines UV-Hochleistungsstrahlers (3), der eine Wellenlänge zwischen 60 nm und 320 nm aufweist, ausgesetzt. Eine Hochleistungsquecksilberlampe (3) mit einer Wellenlänge von 185 nm kann ebenfalls verwendet werden. Unter dem Einfluß dieser UV-Strahlung kommt es zu einer Zersetzung der metallorganischen Verbindung unter gleichzeitiger Bildung

einer metallischen Schicht (2M).

Fig.1

## Verfahren zur Herstellung von metallischen Schichten

Die Erfindung bezieht sich auf ein Verfahren zur Herstellung von ganzflächigen oder partiellen metallischen Schichten gemäß dem Oberbegriff des Patentanspruches 1.

Aus der Mat.RES.Soc.Symp.Proc.Vol.75, 1987 ist ein Verfahren zur Herstellung von metallischen Schichten auf einem Substrat bekannt. Bei diesem Verfahren werden in Lösungsmitteln gelöste metallorganische Verbindungen auf die Oberfläche eines Substrates aufgetragen. Zur Ausbildung einer metallischen Schicht auf dem Substrat wird die Lösung mit einer Lichtquelle hoher Leistung bestrahlt. Für die Fertigstellung der metallischen Schichten sind zusätzliche Trocknungsprozesse erforderlich.

Der Erfindung liegt ausgehend von dem eingangs genannten Stand der Technik die Aufgabe zugrunde, ein Verfahren aufzuzeigen, mit dem metallische Schichten einfacher und energiesparender als bisher auf Substrate aufgetragen werden können.

Diese Aufgabe wird erfindungsgemäß durch die Merkmale des Patentanspruches 1 gelöst.

Mit Hilfe des erfindungsgemäßen Verfahrens können aus pulverförmigen metallorganischen Verbindungen, die auf ein Substrat aufgetragen werden, alleine durch energiereiche UV-Photonenbestrahlung unmittelbar metallische Schichten gebildet werden. Vorzugsweise besteht der metallische Anteil der metallorganischen Verbindung aus Kupfer, Palladium, Platin oder Gold. Unter Zuhilfenahme von Masken lassen sich die metallischen Schichten an definierter Stelle auf dem Substrat ausbilden. Die nicht mit dem UV-Licht bestrahlten Pulverteilchen können anschließend problemlos von der Oberfläche des Substrats abgenommen werden. Umweltbelastende Lösungsmittel werden nicht freigesetzt. Zusätzliche Trocknungsprozesse entfallen und Benetzungsprobleme beim Auftragen der Lösung auf die Substratoberfläche treten nicht auf. Mit dem erfindungsgemäßen Verfahren können selbstverständlich auch metallische Schichten aus Lösungsfilmen abgeschieden werden. Hierfür werden die metallorganischen Verbindungen in einem Lösungsmittel gelöst und durch Tauchen oder Sprühen auf die Oberfläche des Substrates aufgetragen.

Für die Bestrahlung der pulverförmigen metallorganischen Verbindung wird ein UV-Hochleistungsstrahler mit quasigepulster Betriebsart verwendet. Das gleiche gilt für die aus einer Lösung aufgetragenen pulverformigen metallorganischen Verbindung. Das von dem Hochleistungsstrahler ausgesendete Licht weist eine Wellenlänge auf, die je nach Gasfüllung des UV-Hochleistungsstrahlers zwischen 60 nm und 320 nm liegt. Anstelle des UV-Hochleistungsstrahlers kann zur Ausbildung der metallischen Schichten auf dem Substrat auch eine Hochleistungsquecksilberlampe mit einer Wellenlänge von 185 nm verwendet werden. Für die Ausbildung der metallischen Schichten werden pulverförmiger Metallacetate, Metallacetylacetonate und Metallformiate auf die Substratoberfläche aufgetragen. Die Dicke der aufgetragenen Pulverschicht beträgt 10 nm bis 500 nm. Metallische Schichten aus Palladium können auch durch Auftragen einer palladiumhaltigen Lösung auf das Substrat gebildet werden. Die aufgetragenen Lösungen werden vor der Bestrahlung getrocknet. Das Substrat, auf welchem die metallische Schicht ausgebildet werden soll, kann aus einem organischen oder anorganischen Werkstoff bestehen. Eine besonders gute Haftfestigkeit der metallischen Schicht kann auf Substraten aus Aluminiumoxid und Aluminiumnitrid (AlN) erzielt werden. Die fertiggestellten Schichten können zusätzlich durch stromlose oder galvanische Metallisierung verstärkt werden.

Weitere erfindungswesentliche Merkmale sind in den Unteransprüchen gekennzeichnet.

Es zeigen:

Figur 1: Die strukturierte Beschichtung eines Substrats,

Figur 2: das beschichtete Substrat gemäß Figur 1,

Figur 3: ein ganzflächig beschichtetes Substrat mit zusätzlicher Metallisierung.

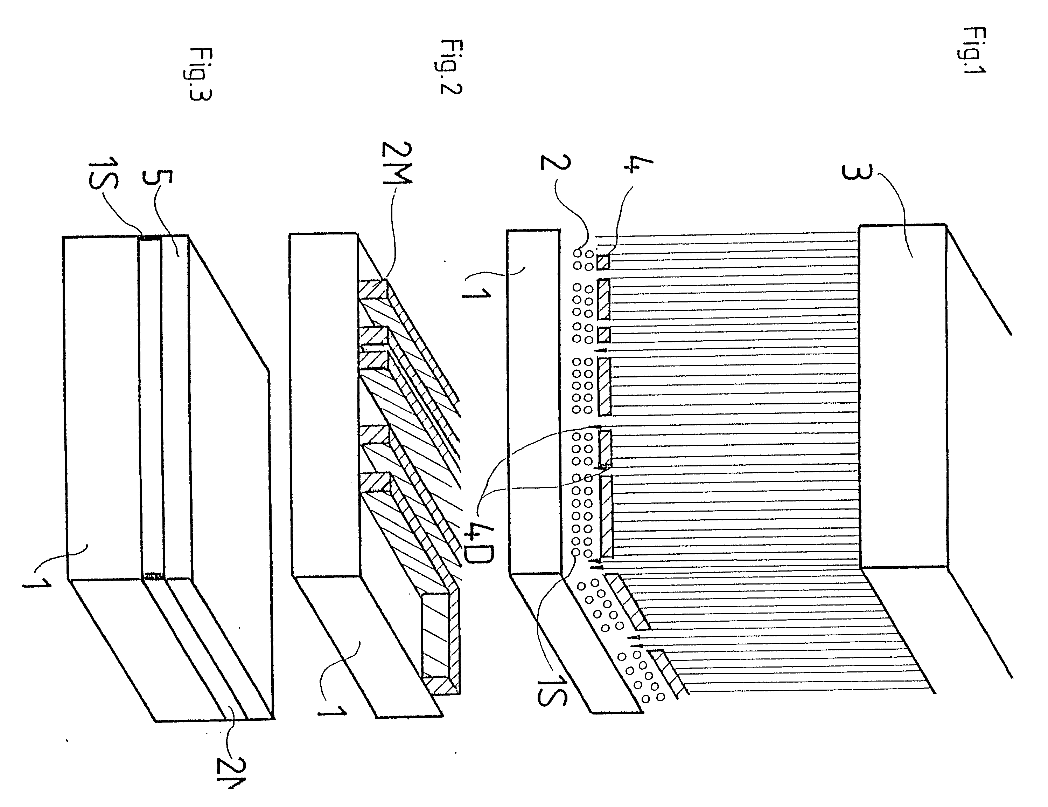

Figur 1 zeigt ein flächiges Substrat 1 mit rechteckigem Querschnitt, auf dessen Oberfläche eine metallische Schicht abgeschieden werden soll. Das Substrat 1 ist bei dem hier dargestellten Ausführungsbeispiel aus Aluminiumoxid ($Al_2O_3$) gefertigt. Die metallische Beschichtung kann jedoch auch auf anderen Substraten (hier nicht dargestellt) aus einem organischen oder anorganischen Werkstoff aufgebracht werden. Die verwendeten Substrate können jede beliebige geometrische Form aufweisen, vorzugsweise werden jedoch dünne Platten verwendet, die aus Aluminiumnitrid, Borsilikatglas, Polyimid, Gummi, Papier oder Pappe sowie aus keramisch gefüllten oder glasgewebeverstärkten Fluorkunststoffen hergestellt sind. Auf die gereinigte Oberfläche des Substrats 1 wird zunächst eine pulverförmige metallorganische Verbindung 2 aufgetragen. Die Dicke des aufgetragenen Pulvers wird so gewählt, daß die zu bildende metallische Schicht im fertigen Zustand eine Dicke von 50 nm aufweist. Das verwendete Pulver weist vorzugsweise eine Korngröße von 25 bis 150 $\mu$m auf. Als metallorganische Verbindung können Metallacetate, Metallacetylacetonate und Metallformiate verwendet werden. Soll beispielsweise die zu bildende metallische Schicht 2M aus Palladium bestehen, so wird auf die zu beschichtende Oberfläche 1S des Substrates 1 pulverförmiges Palladiumacetat aufgetragen. Zur Ausbildung einer aus Kupfer bestehenden metallischen Schicht wird Kupferacetat oder eine andere metallorganische Verbindung aufgetragen, deren metallischer Anteil aus Kupfer besteht. Ein strukturiertes Auftragen des Pulvers ist mittels Siebdruck oder Sprühen möglich.

Erfindungsgemäß kann das Substrat 1 zur Ausbildung einer strukturierten oder nichtstrukturierten metallischen Schicht auch mit einem Film 2 aus einem Lösungsmittel überzogen werden, in dem die metallorganische Verbindung gelöst ist. Auf ein oben beschriebenes Substrat 1 kann bspw. eine Palladiumacetatlösung durch Tauchen der Substratoberfläche in dieser Lösung aufgebracht werden. Die Schicht 2M kann auch durch Auftragen einer Palladiumchloridlösung gebildet werden. Diese Lösung ist in dieser Form im Handel erhältlich. Nach dem Auftragen muß sie lediglich noch eingetrocknet werden. Ferner besteht die Möglichkeit Cyclopentadienylpalladiumallyl, das in Pulverform vorliegt, in Alkohol oder Wasser zu lösen, und auf das Substrat ! aufzutragen. Die Verwendung von pulverförmigem Cyclopentadienylpalladiumchlorid, das zur Ausbildung einer Lösung ebenfalls in Alkohol oder Wasser gelöst wird, ist ebenfalls möglich. Alle aufgetragenen Lösungen müssen vor der Bestrahlung in einem Ofen eingetrocknet werden. Die Lösungen werden so dick auf das Substrat aufgetragen, daß die metallische Schicht 2M eine Dicke zwischen 0,5 und 50 nm aufweist. Das so beschichtete Substrat 1 wird dann ebenso weiterbehandelt wie das Substrat, auf dessen Oberfläche die pulverförmige metallorganische Verbindung aufgetragen ist.

In definiertem Abstand über der zu beschichtenden Oberfläche 1S des Substrates 1 ist ein UV-Hochleistungsstrahler 3 angeordnet. In Figur 1 ist dieser Hochleistungsstrahler 3 nur schematisch dargestellt. Eine detaillierte Beschreibung eines solchen Hochleistungsstrahlers 3 kann der EP-OS 0 254 111 entnommen werden. Der Hochleistungsstrahler 3 besteht aus einem durch eine einseitig gekühlte Metallelektrode (hier nicht dargestellt) und ein Dielektrikum (hier ebenfalls nicht dargestellt) begrenzten und mit einem Edelgas oder Gasgemisch gefüllten Entladungsraum (hier nicht dargestellt). Das Dielektrikum und die auf der dem Entladungsraum abgewandten Oberfläche des Dielektrikums liegende zweite Elektrode sind für die durch stille elektrische Entladung erzeugte Strahlung transparent. Durch diese Kon struktion und durch eine geeignete Wahl der Gasfüllung wird ein großflächiger UV-Hochleistungsstrahler mit hohem Wirkungsgrad geschaffen. Mit Hilfe einer Gasfüllung aus Hellium bzw. Argon kann eine UV-Strahlung mit einem Wellenlängenbereich zwischen 60 und 100 nm bzw. 107 und 165 nm erzeugt werden. Mit einer Gasfüllung aus Xenon kann mit dem Hochleistungsstrahler 3 UV-Strahlung mit einer Wellenlänge zwischen 160 und 190 nm erzeugt werden, wobei das Maximum hierbei bei 172 nm liegt. Mit einer Gasfüllung aus Argonfluorid bzw. Kryptonfluorid kann UV-Strahlung im Bereich von 180 bis 200 nm bzw. 240 bis 255 nm erzeugt werden. Mit einem Gasgemisch aus Xenon und Chlor läßt sich mit dem Hochleistungsstrahler eine UV-Wellenlänge von 300 bis 320 nm erzeugen. Der Hochleistungsstrahler 3 arbeitet im quasigepulsten Betrieb. Soll das zu beschichtende Substrat 1 auf seiner gesamten Oberfläche mit einer Metallschicht versehen werden, so wird ein Hochleistungsstrahler 3 verwendet, dessen Strahlungsfeld der Größe der Substratoberläche 1S entspricht. Falls die aufzutragende metallische Schicht 2M eine definierte Struktur aufweisen soll, besteht die Möglichkeit, daß zwischen dem Hochleistungsstrahler 3 und der Oberfläche 1S des Substrates 1 eine oder mehrere optische Linsen (hier nicht dargestellt) angeordnet werden. Mit deren Hilfe kann eine die gewünschte Struktur bestimmende Maske auf der Oberfläche 1S des Substrates 1 abgebildet werden. Dies ist insbesondere dann vorteilhaft, wenn die aufzutragende Schicht komplexe Strukturen wie Linien oder Spiralen aufweisen soll. Mit Hilfe der Linsen können die Strahlen so fokussiert werden, daß sie gerade die Breite dieser Linien bzw. Spiralen aufweisen. Die Maske kann jedoch auch unmittelbar über der Pulverschicht 2 bzw. der aufgetragenen Lösung 2 positioniert werden. Die Maske 4 ist an die Abmessung der Oberfläche angepaßt und weist gerade an den Stellen, an denen die strukturierte metallische Beschichtung 2M ausgebildet werden soll, Durchlässe 4D für die von dem UV-Hochleistungsstrahler 3 kommende Strahlung auf. Die Bestrahlung der Pulverschicht 2 oder eines Lösungsfilms durch die Durchlässe 4D hindurch wird wenige Sekunden bis hin zu einigen Minuten lang durchgeführt. Diese Zeit wird von den jeweiligen Gegebenheiten bestimmt. Durch das Bestrahlen der Pulverschicht 2 oder des Lösungsfilms 2 wird die metallorganische Verbindung unter gleichzeitiger Bildung der metallischen Schicht zersetzt. Bei Verwendung einer Maske 4 haben die gebildeten metallischen Schichten die Breite und die Länge der in der Maske 4 vorgesehenen Durchlässe 4D. Die Pulverschichten 2, welche durch die Maske 4 vor einer Bestrahlung abgeschirmt wurden, können jetzt mit Hilfe eines Gasstrahles von der Oberfläche 1S des Substrates 1 entfernt werden. Die nicht bestrahlten Reste des Lösungsfilms werden abgewaschen.

Anstelle des eingangs beschriebenen UV-Hochleistungsstrahlers 3 kann auch eine Hochleistungsquecksilberlampe mit einer Wellenlänge von 185 nm für die Ausbildung der metallischen Schichten eingesetzt werden. Erfindungs-gemäß kann die Geometrie des verwendeten UV-Hochleistungsstrahlers 3 bzw. der Hochleistungsquecksilberlampe an die Geometrie der zu beschichtenden Substrate angepaßt werden. Es ist bspw. durchaus möglich, die Beschichtung von rechteckigen Substraten im Sekundentakt auf einem Fließband durchzuführen. Hierfür wird die Lampengeometrie auf den rechteckigen Querschnitt des zu beschichtenden Substrats abgestimmt. Zusätzlich werden die Länge der Lampe und die Geschwindigkeit des Bandes, auf welche die Substrate gelegt werden, so aufeinander abgestimmt, daß das jeweilige Substrat 1 solange unter einer Lampe 3 hindurch bewegt wird, wie es für die Ausbildung der metallischen Schicht 2M auf seiner Oberfläche 2S erforderlich ist. Die gewünschte Produktionsrate kann durch Wahl der o.g. Parameter erzielt werden.

Figur 2 zeigt ein Substrat 1, das mit dem erfindungsgemäßen Verfahren unter Verwendung des UV-Hochleistungsstrahlers 3 und der in Figur 1 gezeigten Maske 4 beschichtet wurde. Das Substrat 1 weist die zu Beginn des Verfahrens festgelegte strukturierte Beschichtung auf, die zum einen mit Hilfe der Maske 4 und zum anderen durch ein gezieltes Auftragen der pulverförmigen metallorganischen Verbindung erreicht wird.

In Figur 3 ist ein weiteres Substrat 1 dargestellt, dessen Oberfläche 1S vollständig von einer metallischen Schicht 2M überzogen ist. Die Ausbildung dieser metallischen Schicht 2M erfolgt wiederum durch Auftragen einer metallorganischen Verbindung in Pulverform bzw. einer Lösung 2 auf die Oberfläche 1S des Substrates 1. Anschließend wird die Pulverschicht 2 bzw. der Lösungsfilm 2 komplett von dem UV-Hochleistungsstrahler 3 bestrahlt, so daß das gesamte Pulver bzw. der Lösungsfilm 2 zersetzt und in eine metallische Schicht 2M umgewandlet wird. Die in Figur 3 dargestellte Metallschicht 2M ist zusätzlich durch einen weiteren metallischen Überzug 5 verstärkt. Dieser metallische Überzug 5, der aus Kupfer oder einem anderen Metall bestehen kann, läßt sich durch stromlose oder galvanische Metallisierung ausbilden. Die in Figur 2 dargestellten strukturierten Metallschichten 2M können in gleicher Weise verstärkt werden.

## Ansprüche

1. Verfahren zur Herstellung von ganzflächigen oder partiellen metallischen Schichten (2M) aus einer metallorganischen Verbindung auf einem Substrat (1) durch Bestrahlung mit einer Lichtquelle (3),dadurch gekennzeichnet, daß die metallorganische Verbindung (2) der Einwirkung von UV-Photonen einer definierten Wellenlänge ausgesetzt wird.

2. Verfahren nach Anspruch 1, dadurch gekennzeichnet, daß zur Herstellung der ganzflächigen oder partiellen metallischen Schichten (2M) eine pulverförmige metallorganische Verbindung in vorgegebener Weise mittels Siebdruck oder Sprühen auf die Oberfläche (1S) des Substrats (1) aufgetragen wird.

3. Verfahren nach Anspruch 1, dadurch gekennzeichnet, daß zur Herstellung der flächigen oder partiellen metallischen Schichten (2M) ein Lösungsfilm, der eine metallorganische Verbindung enthält, auf die Oberfläche (1S) des Substrates (1) aufgetragen wird.

4. Verfahren nach einem der Anspruche 1 bis 3, dadurch gekennzeichnet, daß die ganzflächigen oder partiellen metallischen Schichten (2M) durch stromlose oder galvanische Metallisierung verstärkt werden.

5. Verfahren nach einem der Ansprüche 1 bis 4, dadurch gekennzeichnet, daß zur Herstellung von ganzflächigen oder partiellen metallischen Schichten (2M) die pulverförmige metallorganische Verbindung (2) oder die aufgetragene Lösung vollständig oder partiell der Strahlung eines UV-Hochleistungsstrahlers (3) ausgesetzt wird.

6. Verfahren nach Anspruch 5, dadurch gekennzeichnet, daß zur Herstellung von ganzflächigen oder partiellen metallischen Schichten (2M) die pulverförmige metallorganische Verbindung (2) oder die aufgetragene Lösung vollständig oder partiell mit einem Hochleistungsstrahler (3) bestrahlt wird, der UV-Strahlung mit einer Wellenlänge zwischen 60 nm und 320 nm erzeugt.

7. Verfahren nach einem der Ansprüche 1 bis 6, dadurch gekennzeichnet, daß zur Herstellung von ganzflächigen oder partiellen metallischen Schichten (2M) pulverförmige Metallacetate, Metallacetylacetonate oder Metallformiate in einer Dicke zwischen 10 und 500 nm auf das Substrat (1) aufgetragen werden.

8. Verfahren nach einem der Ansprüche 2 bis 7, dadurch gekennzeichnet, daß zur Herstellung von ganzflächigen oder partiellen metallischen Schichten (2M) pulverförmige metallorganische Verbindungen oder Lösungen verwendet werden, deren Metallanteil durch Palladium, Kupfer, Platin oder Gold gebildet wird.

9. Verfahren nach einem der Ansprüche 2 bis 7, dadurch gekennzeichnet, daß zur Herstellung von ganzflächigen oder partiellen metallischen Schichten eine Lösung in Form von Palladiumacetat, Palladiumchlorid, Cyclopentadienylpalladiumallyl oder Cyclopentadienylpalladiumchlorid auf das Substrat (1) aufgetragen werden.

10. Verfahren nach einem der Anspruche 1 bis 9, dadurch gekennzeichnet, daß zur Herstellung von ganzflächigen oder partiellen metallischen Schichten (2M) ein in der DE-OS 02 54 111 offenbarter Hochleistungsstrahler (3) mit einer Gasfüllung aus Helium, Argon, Argonfluorid, Kryptonfluorid, Xenon oder einem Gasgemisch aus Xenon und Chlor verwendet wird, der eine UV-Strahlung im Wellenlängenbereich zwischen 60 nm und 320 nm erzeugt.

11. Verfahren nach einem der Ansprüche 1 bis 10, durch gekennzeichnet, daß die ganzflächigen oder partiellen Schichten (2M) auf die Oberfläche (1S) von Substraten (1) aus organischen oder anorganischen Werkstoffen aufgetragen werden.

12. Verfahren nach einem der Ansprüche 1 bis 11, dadurch gekennzeichnet, daß zur Herstellung der ganzflächigen oder partiellen metallischen Schichten (2M) eine Hochleistungsquecksilberlampe mit einer Wellenlänge von 185 nm verwendet wird.

Fig.1

3

4

2

1

1S

4D

Fig.2

2M

1

Fig.3

5

1S

1

2M

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 904 783 (NARA)<br>--- | | C 23 C 18/14 |
| A | EP-A-0 272 420 (GENERAL ELECTRIC)<br>----- | | |

RECHERCHIERTE SACHGEBIETE (Int. Cl.5)

C 23 C
G 03 C
H 05 K
C 04 B

Der vorliegende Recherchenbericht wurde für alle Patentansprüche erstellt

| Recherchenort | Abschlußdatum der Recherche | Prüfer |
|---|---|---|
| DEN HAAG | 12-08-1989 | NGUYEN THE NGHIEP |